# EUROPEAN PATENT SPECIFICATION

(11) **EP 0 592 688 B1**
(45) Date of publication and mention of the grant of the patent: **10.06.1998**
(21) Application number: 93909413.2
(22) Date of filing: 23.04.1993
(51) Int. Cl.: G11C 11/406

(54) **Microprocessor system having dynamic RAM**
Mikroprozessorsystem mit dynamischem RAM Speicher
Système à microprocesseur comportant une mémoire à accès aléatoire du type dynamique

(30) Priority: 24.04.1992 JP 131598/92
(43) Date of publication of application: 20.04.1994
(73) Proprietor: CITIZEN WATCH CO. LTD., Shinjuku-Ku Tokyo 163-04 (JP)
(72) Inventor: FUJISAWA, Kenzo, Hanno-shi, Saitama 357 (JP)
(74) Representative: Lawrence, John Gordon
(86) International application number: PCT/JP93/00529
(87) International publication number: WO 93/22769

(56) References cited:
- JP-A- 3 058 378
- JP-A- 3 152 790
- JP-A- 3 183 095
- EDN ELECTRICAL DESIGN NEWS, vol.34, no.8, April 1989, NEWTON, MASSACHUSETTS US pages 155 - 166 GUMM ET AL. 'UNRAVELING THE INTRICACIES OF DYNAMIC RAMS'
- IEEE MICRO, vol.8, no.1, February 1988, NEW YORK US pages 8 - 27 NICOUD 'VIDEO RAMS'

## Description

### Technical Field

The present invention relates to a microprocessor system.

### Background Technique

A main memory device in a personal computer includes for general use thereof a dynamic RAM which is advantageous in view of the unit cost thereof in a memory capacity, and memory capacities of semiconductors are increased with the technical progress thereof and hence personal computers are minimized and made thinner.

A dynamic RAM is needed to be routinely refreshed for holding any data stored therein.

Conventional personal computers employ a RAS (Row Address Strobe) -only refresh procedure as a most standard technique wherein a CAS (Column Address Strobe) signal is set to a high level and a RAS signal is varied in conformity with refresh addresses applied to an address terminal, and refresh is achieved by selecting all refresh addresses. The RAS-only refresh procedure is a common refresh technique for systems using dynamic RAMs.

The RAS signal serves to latch a row address supplied from the outside to select a memory cell of a dynamic RAM in an internal row adress decoder.

The CAS signal serves to latch a column address supplied from the outside to select a memory cell of a dynamic RAM in an internal column address decoder.

With reference to the accompanying drawings, an access to a dynamic RAM and the RAS-only refresh will be described.

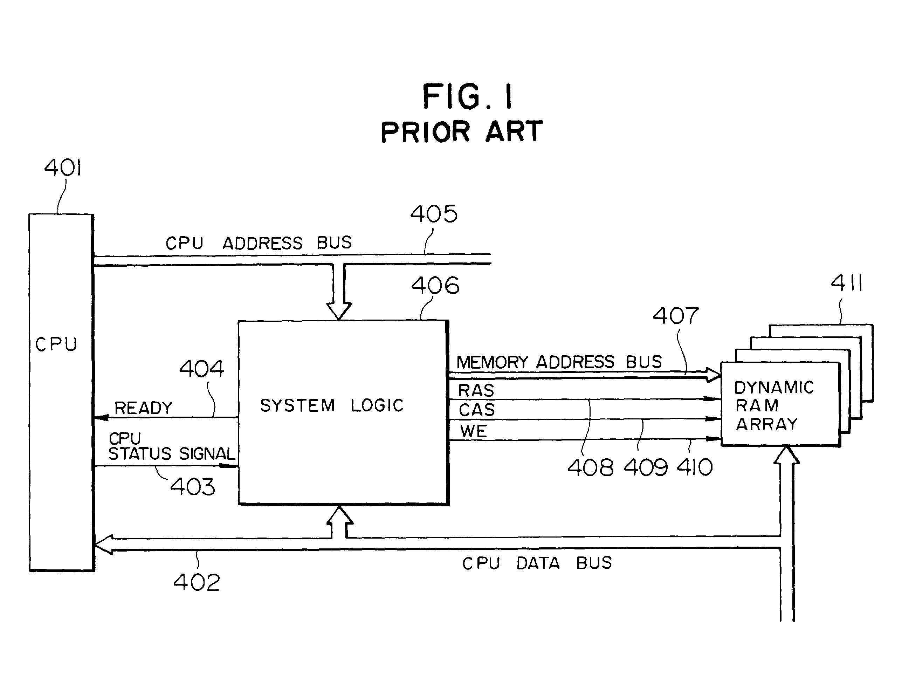

As illustrated in FIG.1, in the case where a central processing unit (hereinafter referred to as a CPU.) 401 reads data from and writes data into a dynamic RAM array 411, the CPU 401 provides a read or write address to a CPU address bus 405 and further provides a CPU status signal 403 to a system logic 406 for instruction to read/write the data from/into the dynmic RAM array 411.

The system logic 406 transmits the address provided from the CPU address bus 405 onto a memory address bus 407 as a row address and a column address of the dynamic RAM.

The system logic 406 further switches the RAS signal 408 from an "H" level to an "L" level while providing the row address, and latches that signal in the dynamic RAM array 411 as the row adress of the dynamic RAM.

Thereafter, the system logic 406 switches its output and the CAS signal 409 from the row address to the column address and from an "H" level to an "L" level, respectively, and latches that signal in the dynamic RAM array 411 as the column address of the dynamic RAM.

At that time, if the CPU status signal 403 from the CPU 401 is an instruction allowing to write associated data in the dynamic RAM, a WE (Write Enable) signal 410 is switched from "H" to "L" level, thereby writing the write data on the CPU data bus 402 transferred from the CPU 401 in the dynamic RAM array 411.

In contrast, if the CPU status signal 403 from the CPU 401 is an instruction allowing to read associated data from the dynamic RAM, the system logic 406 designates a row address and a column address, and thereafter, with the lapse of a certain time, data read from the dynamic RAM array 411 is outputted on the CPU data bus 402 and is received by the CPU 401.

In the case where associated data is read out from the dynamic RAM array 411, delayed by proper time, the system logic 406 adjusts a timing of the CPU 401 to incorporate therein the read data on the CPU bus 402 with use of a READY signal 404.

The foregoing is for a description of the read/write operation by the CPU 401 from/in the dynamic RAM array 411.

The system logic 406 must refresh as above the dynamic RAM array 411 for a predetermined time interval whilst the CPU 401 reads/writes asociated data from/in the dynamic RAM array 411.

The system logic 406 includes therein circuit for generating row addresses, which serves to interrupt the CPU 401 during each predetremined time inerval and output a row address, and switch only the RAS signal 408 from the "H" level to the "L" level, maintaining the CAS signal 409 at the "H" level.

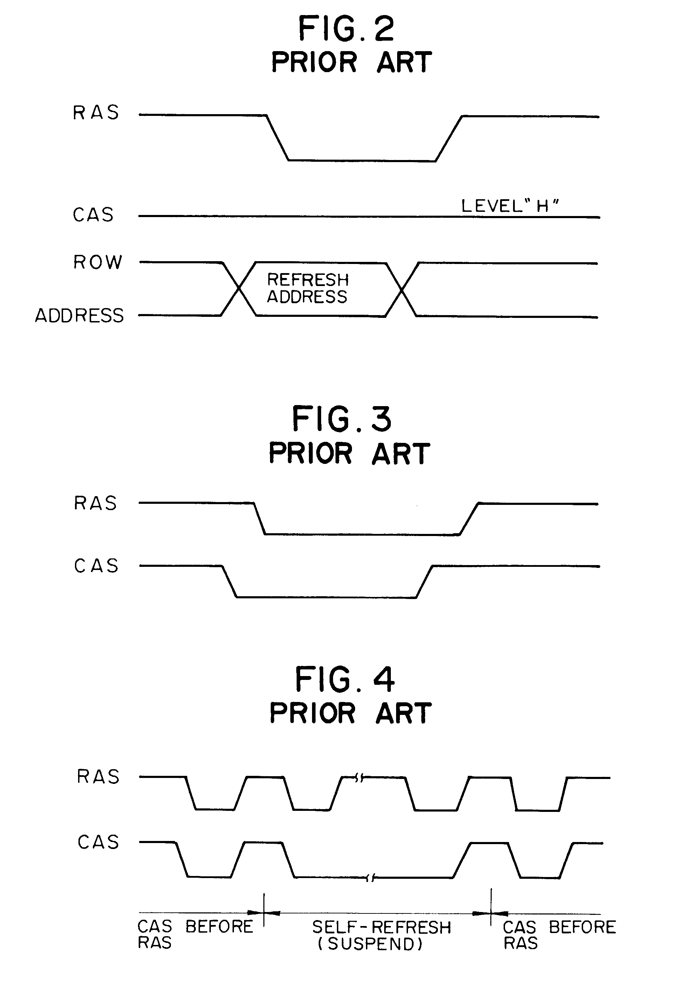

The aforementioned refreshing technique is called a RAS-only refresh. Referring to FIG. 2, there is illustrated a timing relationship between the RAS signal 408 and the row address in the RAS-only refresh.

As illustrated in FIG. 2, prior to the RAS signal 408 switched from the "H" level to the "L" level, a row address has previously been stabilized on the memeory address bus 407, and when the RAS signal 408 is switched from the "H" level to "L" level, the row address is latched in the dynamic RAM array 411.

Thereafter, in the dynamic RAM data stored therein at the designated row addresses read out therefrom, and it is again stored at the original address when the RAS signal is switched from the "L" to "H" level.

Such a RAS-only refresh technique described above with reference to FIGs. 1 and 2 is relatively simplified in its control, and hence is useful in many personal computers (those from IBM and compatible ones therewith). Accordingly, manufacturers of the system logic 406 of FIG.1, which controls the refreshing of a dynamic RAM, all adopt the RAS-only refresh technique. This is inevitably required for ensuring compatibility of associated systems.

RAS-only refreshing, however, suffers from problems that it has a greater consumed current in operation, and that it requires a very greater consumed current even when data holding (suspending) by the dynamic array is performed while restricting to the minimum the total of consumed currents other than that in the dynamic RAM array.

Further, a portion in the system logic which controls the refresh addressing needs to generate a refresh address even during the suspension and hence requires ordinary operation. This causes a greater consumed current during the suspension.

Portable personal computers and handy computers include systems driven by a battery which are therefore cost effective and sometimes enjoy the use of a large capacity dynamic RAM as a main memory.

Such systems driven by a battery, however, has a difficulty that its life is severely reduced because of a consumed current necessary for the RAS-only refresh being increased.

There is known, for example from Japanese Patent Application A-3058378, dynamic RAM CAS-before-RAS refresh which is accomplished in response to refresh request signal REF.

As shown in Fig. 3 the CAS-before-RAS refresh is such that a CAS signal is switched from an "H" level to an "L" level before a RAS signal is switched from an "H" level to an "L" level, and the operation enters a CAS-before-RAS refresh cycle provided the CAS signal remains at the "L" level even after the RAS signal is altered from the "H" to "L" level.

The CAS-before-RAS refresh technique does not need a refreshing address differing from the RAS-only refresh and allows a row of the dynamic RAM designated by a refresh address generated by a counter included in the dynamic RAM to be refreshed.

The CAS-before-RAS refresh is further advantageous in that it is easily changed to the self-refresh operation. The self-refresh enjoys a least consumed current and is suitable for data holding by a dynamic RAM.

Referring to FIG. 4, there will be described the self-refresh.

As understood from FIG. 4, the self-refresh switches a RAS signal from an "H" level to an "L" level and in the opposite way. This ensures lower consumed current refresh operation.

It is further possible to transfer the operation with ease from the CAS-before-RAS refresh to the self-refreshing and in the opposite way.

In the RAS-only refresh and the CAS-before-RAS refresh, an actual measurement of the mean consumed current upon the refreshing reads 80 mA for the RAS-only refresh, 60 mA for the CAS-before-RAS refresh, and 30 mA for the self-refresh.

In prior art systems, many personal computers which support only the RAS-only refresh are obliged to the use of the RAS-only refresh, which is perplexed with a greater consumed current, for data holding by the dynamic RAM.

When the RAS-only refresh is used for ordinary refresh, use of the self-refresh for data holding by the dynamic RAM causes very difficult control.

The reason is that a refresh address upon the RAS-only refresh is supplied externally of the dynamic RAM array 411 as illustrated in FIG. 1, while a refresh address upon the self-refresh is supplied from a counter included in the dynamic RAM array 411. This causes a discontinuous change in refresh addresses upon the operation being switched from the RAS-only refresh to the self-refresh.

The present invention has been made in view of the foregoing circumstances, and has for its object to provide a microprocessor system having a refresh switching circuit and a dynamic RAM wherein the prior art RAS-only refresh is switched to the CAS-before-RAS refresh which is with a less consumed current, and the dynamic RAM is easily transferred to its data holding state (suspension), and further the refresh switching circuit is compatible with those of prior art personal computer systems in view of the hardware and software.

### Disclosure Of The Invention

To achieve the above object there is provided a microprocessor system as defined by claim 1.

In the microprocessor system according to an embodiment of the invention, the refresh switching circuit includes means for performing a switching operation between said CAS-before-RAS refresh and a self-refresh, thereby providing a data holding by said dynamic RAM array with a lower consumed electric power.

Further, according to another embodiment of the invention, the microprocessor system comprises an external terminal for inputting thereto a clock signal having a periodic time within the allowable range of data holding time in said dynamic RAM array, thereby enabling said refresh switching circuit to perform the self-refresh operation even when both said central processor and said system logic are stopped during the self-refresh operation.

The above and many other advantages, features and additional objects of the present invention will become manifest to those versed in the art upon making reference to the following detailed description and accompanying drawings in which preferred structual embodiments incorporating the principles of the present invention are shown by way of illustrative example.

### Brief Description Of The Drawings

FIG. 1 is a circuit diagram illustrating the arrangement of a prior art dynamic RAM;
FIG. 2 is a timing chart illustrating RAS-only refresh;
FIG. 3 is a timing chart illustrating CAS-before-RAS refresh;
FIG. 4 is a timing chart illustrating the operation of the prior art wherein the operation is switched from, the CAS-before-RAS refresh to data holding in the dynamic RA and further returned to the CAS-before-RAS refresh;
FIG. 5 is a circuit diagram illustrating the arrangement of a dynmaimc RAM according to the present invention;
FIG. 6 is a timing chart illstrating RAS-only refresh issued by a system logic to a refresh switching circuit;
FIG. 7 is a timing chart illustrating a process wherein a waveform of the RAS-only refresh issued by the system logic to the refresh switching circuit is converted to that of the CAS-before-RAS refreshing in the refresh switching circuit;
FIG. 8 is a circuit diagram illusrating the refresh switching circuit of the present invention; and
FIG. 9 is a timing chart illustrating the process wherein the operation is transferred from the CAS-before-RAS refresh to the data holding by the dynamic RAM and is returned to the CAS-before-RAS refresh, and further illustrating sef-refresh in the data holding by the dynamic RAM.

### Preferred Embodiments To Practice The Invention

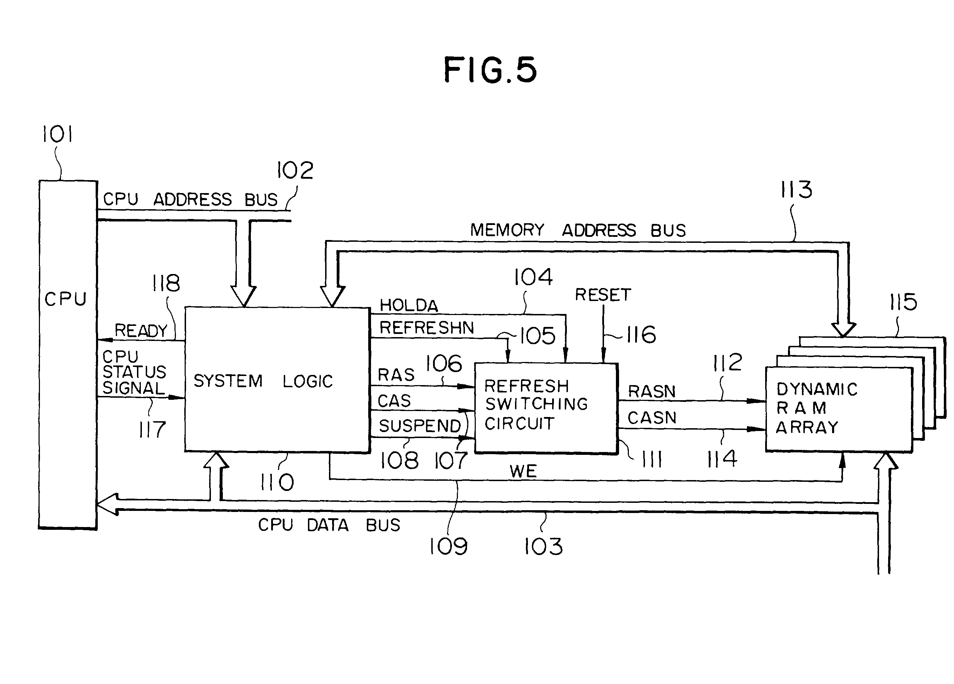

In the following, a preferred embodiment of the present invention will be described with reference to FIGs. 5 to 9.

Referring to FIG. 5, there will be described the arrangement of a dynamic RAM of the present invention.

As illustrated in FIG. 5, the dynamic RAM of the present invention comprises a CPU 101, a system logic 110 for controlling a dynamic RAM array 115 on the basis of an instruction from the CPU 101, and a refresh switching circuit 111 for switching RAS-only refresh issued from the system logic 110 to the dynamic RAM array 115 to CAS-before-RAS refresh.

When the CPU 101 of FIG. 5 accesses the dynamic RAM array array 115 to read/write data from/in the same, the CPU 101 transmits a read/write address onto a CPU address bus 102, and provides a read/write instruction to the system logic 11 through a CPU status signal 117.

The system logic 110 separates the address transmitted through the CPU address bus 102 into a row address and a column address for the dynamic RAM array 115 and transfers those addresses onto a memory address bus 113.

The system logic 110 further switches a RAS signal 106 from the "H" to "L"level whilst transmitting the row address.

The refresh switching circuit 111, as receiving the RAS signal 106 changing from the "H" to "L" level, switches a RASN signal 14 altered to the CAS-before-RAS therein from the "H" to "L" level, and latches it in the dynamic RAM array 115 as the row address of the dynamic RAM.

Thereafter, the output from the system logic 110 is altered from the address to the column address, and a CAS signal 107 is changed from the "H" level to the "L" level.

The refresh switching circuit 111, as receiving the CAS signal 107 changing from the "H" level to the "L" level switches a CASN signal altered to the CAS-before-RAS therein from an "H" level to an "L" level, and latches it in the dynamic RAM array as the column address of the dynamic RAM.

Provided the CPU status signal 117 from the CPU 101 is of a write instruction into the dynamic RAM array 115, a WE (Write Enable) signal 109 is changed from an "H" level to an "L" level, and thereby writing write data on the CPU data bus 103 provided from the CPU 101 in the dynamic RAM array 115.

Provided the CPU status signal 117 from the CPU 101 is of a read instruction from the dynamic RAM array 115 after the passage of a certain time since the designation of the row and column addresses by the system logic 110 is tranmitted onto the CPU data bus 103 and is received by the CPU 101 as read data.

In the case where the data read out from the dynamic RAM array 115 is outputted with a delay, the system logic 110 adjusts a timing of the CPU 101 incorporating the data read out onto the CPU data bus 103 with use of a READY signal 118.

The foregoing is a description of the read/write operation of the CPU 101 from/in the dynamic RAM array 115.

In accordance with the present invention, the RAS-only refresh in the prior art personal computers is switched to the CAS-before-RAS refresh through the refresh switching circuit, and the operation is transferred with ease to the data holding (suspension) by the dynamic RAM and compatibility with the prior art personal computer systems is ensured in view of both hardware and software.

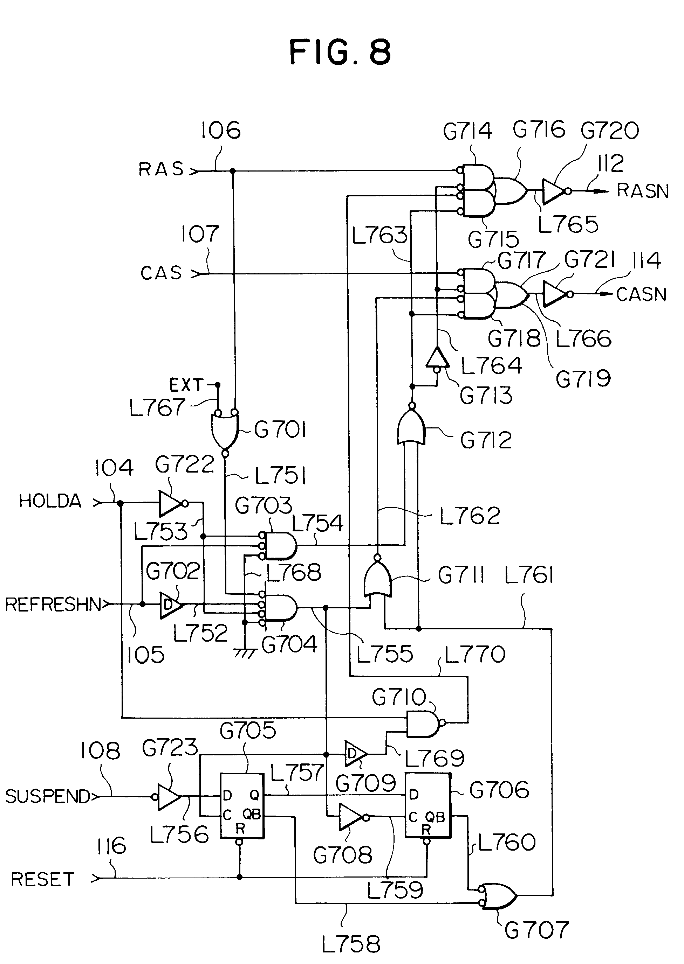

Hereinafter, a concrete circuit arrangement of the refresh switching circuit illustrated in FIG. 5 will be described with reference to a circuit diagram illustrated in FIG. 8. The following description is done with reference to FIGs. 5 and 8.

As illustrated in FIG. 8, the RAS signal 106 is fed to respective input terminals of a gate G701 and a composite gate G714, and a signal on another signal line L767 inputted to the other input terminal 767 of the gate G701 is fed from an external terminal (EXT) and acts in a similar manner as the RAS signal 106 during the self-refresh, and further the other input terminal of the composite gate G714 is connected to one terminal L764 of an inverter G713.

The CAS signal is fed to an input terminal of a composite gate G717, and to another input terminal of the composite gate G717 an output signal on an output signal line L764 is fed from the inverter G713.

A HOLDA signal 104 indicative of permission of the refresh is entered to one input terminal of an inverter G722 and to an input terminal of a gate G703.

A REFRESHN signal 105 indicative of a fact of the operation being of refreshing is entered to an input terminal of a gate G703 and to an input terminal of a gate G704.

An output signal on a signal line L753 from the inverter G722 is entered to an input terminal of the gate G703 and to an input terminal of a gate G704.

Further, an output signal from the gate G701 is entered to an input terminal of the gate G704.

An output signal on a signla line 752 from the delay element G702 is entered to an input terminal of the gate G704.

A signal line L768 connected between input terminals of the gate G703 and the gate G704 is connected to ground potential.

Further, an output signal line L754 of the gate G703 is connected to an input terminal of a gate G712.

An output signal line L755 of the gate G704 is connected to an input terminal of the gate G711, and further connected to an input terminal of a delay element G709 to a clock terminal of a flip-flop G705 and to an input terminl of an inverter G708.

A data holding SUSPEND signal line 108 is connected to an input terminal of an inverter G723.

A RESET signal line 116 is connected to a reset terminal of a flip-flop G705 and to a reset terminal of a flip-flop G706.

An output signal line L756 of the inverter G723 is connected to a data terminal of the flip-flop G705.

A Q output signal line L757 of the flip-flop G705 is connected to a data terminal of the flip-flop G706.

A QB output signal line L757 of the flip-flop G705 is connected to an input terminal of a gate G707.

A QB output signal line L760 of the flip-flop G706 is connected to an input terminal of the gate G707.

An output signal line L759 of an inverter G708 is connected to a clock terminal of the flip-flop G706.

An output signal line of the delay element G709 is connected to an input terminal pf the gate G710.

An output signal line L761 of the gate G707 is connected to input terminals of the gates G711 and G712.

An output signal line L770 of the gate G710 is connected to an input terminal of a composite gate G715.

An output signal line L762 of the gate G711 is connected to an input terminal of a composite gate G718.

An output signal line L763 of the gate G712 is connected to an input terminal of the composite gate G718, to an input terminal of the composite gate G715 and to an input terminal of an inverter G713.

An output terminal of the composite gate G714 and an output of the composite gate G715 constitutes a composite gate construction and are directly connected to an input terminal of the composite gate G716.

An output sinal line L765 of the composite gate G716 is connected to an input terminal of a buffer G720, from an output terminal of which buffer G720 a RASN signal 112 is outputted.

An output terminal of the composite gate G717 and an output terminal of the composite gate G718 constructs a composite gate, and are directly connected to an input terminal of a composite gate G719.

An output signal line L766 of the composite gate G719 is connected to an input terminal of a buffer G721, from an output of which buffer a CASN signal 114 is provided.

The gate G701 comprises a 2-input NAND gate, the gate G711 and the gate G712 comprise 2-input NOR gates, respectively. The gate G710 and the gate G70 comprise 2-input NAND gates, and the gate G703 comprises a 3-input NOR gate. The gate G704 comprises a 4-input NOR gate, and the flip-flop G705 and the flip-flop G706 comprise D flip-flops, respectively.

Further, the composite gate G714 and the composite gate G715 comprise 2-input NOR gates, respectively, and the composite gate G716 comprises a 2-input OR gate. The composite gate G717 and the composite gate G718 comprise 2-input NOR gates, respectively, and the composite gate G719 comprises a 2-input OR gate.

The delay element G702 and the delay element G709 comprise integration circuits, respectively, and serve to delay the input signals.

The buffer G720 and the buffer 721 are to satisfactorily drive the dynamic RAM array 115 illustrated in FIG. 5.

In the next place, there will be described circuit operation of the refresh switching circuit illustrated in FIG. 8. The description will be done hereinafter with alternate rerference to FIGs. 5 and 8.

As shown in FIG. 8, the signal line L764 is of the "L" level excepting the refresh, so that the RAS signal 106 and the CAS signal 107 satisfy gate conditions of the composite gate G714 and of the composite gate G717. Accordingly, a signal on the output signal line L765 of the composite gate G716 is inputted to the buffer G720, and the RASN signal 112 is provided on the output terminal of the buffer G720 to drive the dynamic RAM array 115 illustated in FIG. 5. In contrast, a signal on the output signal line L766 of the composite gate G719 is inputed to the buffer G721, and the CASN signal 114 is provided on the output terminal of the buffer G721 to drive the dynamic RAM array 115.

The refresh switching circuit 111 illustrated in FIG. 5 is therefore operated as in the prior art example as to the read/write operation of the dynamic RAM array 115.

The system logic 110 instructs the dynamic RAM array 115 to execute the RAS-only refresh after the lapse of a predetermined certain time.

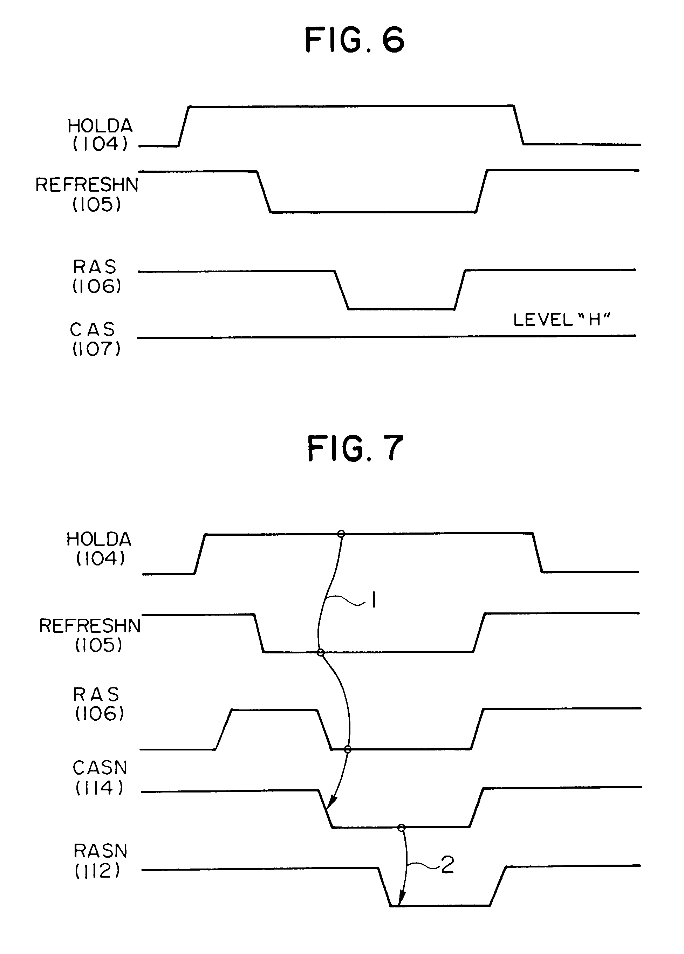

At this time, the refresh switching circuit 111 may switch the operation from the RAS-only refresh to the CAS-before-RAS refresh to refresh the dynamic RAM array 115. In the next place, circuit operation thereof will be described with reference to waveform diagrams shown in Figs. 6 and 7.

Referring to FIG. 6, there is illustrated a timing relationship among the HOLDA signal 104 indicative of a permission of the refresh of the system logic 110 issued from the CPU 101, the REFRESHN signal 105 indicative of the system logic 110 being in the refresh and the RAS signal 106 and the CAS signal 107 both issued from the system logic 110. The refresh switching circuit 111 executes the RAS-only refresh in this timing.

Referring to FIG. 7, there is illustrated a timing chart which indicates a process where the RAS-only refresh is switched to the CAS-before-RAS refresh.

There will be firstly described a switching operation indicated by an arrow 1 with reference to FIGs. 7 and 8.

As shown in FIG. 8, when the HOLDA signal 104 stays at the "H" level and the REFRESHN signal 105 at the "L" level, and the RAS signal 106 is changed from the "H" level to the "L" level, the output signal on the output signal line L754 of the gate G703 is changed to the "H" level and the output signal on the output signal line L763 of the gate G712 is changed to the "L" level.

By this operation, the composite gates G715 and G718 are selected.

Thereafter, when the RAS signal 106 is inputted, the output signal on the output signal line L755 of the gate G704 becomes the "H" level and the output signal on the output signal line L762 of the gate 711 becomes the "L" level.

At that time, logical conditions of the composite gate G718 are satisfied, and therefore the CASN signal 114 becomes the "L" level.

The reason why the delay element G702 is inserted into the REFRESHN signal 105 is that there is existent such a timing that the HOLDA signal 104 is at the "H" level, the REFRESHN signal 105 at the "H" level, and the RAS signal 106 is at the "L" level. In order to discriminate the RAS signal 106 at this time from the RAS signal 106 upon the refresh, the REFRESHN signal 105 is delayed through the delay element G702.

The just-mentioned timing, in which the HOLDA signal 104 is at the "H level, the REFRESHN signal 105 at the "H" level, and the RAS signal 106 is at the "L" level, is produced owing to the access to the dynamic RAM array 115 just before the operation enters the refresh.

Next, a switching operation indicated by an arrow 2 will be described with reference to FIGs. 7 and 8.

The ouput signal on the output signal line 755 of the gate G704 is delayed through the delay element G709, and the output signal on the output signal line 770 of the gate G710 becomes the "L" level to satisfy the logical condition with the "H" level of the HOLDA signal 104. This ensures the logical condition of the composite gate G715 to permit the RASN signal 112 to become the "L" level.

The RASN signal 112 becomes the "L" level later than the CASN signal 114 by the action of the delay element G709.

On the other hand, the RASN signal 112 becomes the "H" level later than the CASN signal 114 by the action of the delay element G709 and, at this time, the switching of the RAS-only refresh to theCAS-before-RAS refresh is completed.

Through this operation, the dynamic RAM array 115 is refreshed by the RASN signal 112 changed to the CAS-before-RAS RAS refresh and the CASN signal 114.

The CAS-before-CASN refresh is such that the CASN signal 114 is switched from the "H" level to the "L" level before the RASN signal 112 is switched, and the dynamic RAM enters a CAS-before-RAS refresh cycle provided the CASN signal 114 stays at at the "L" level even after the RASN signal 112 is switched from the "H" level to the "L" level.

The present refresh technique does not require a refresh address from the memory address bus 113, and enjoys a designated row to be refreshed on the basis of a refresh address generated by the counter in the dynamic RAM.

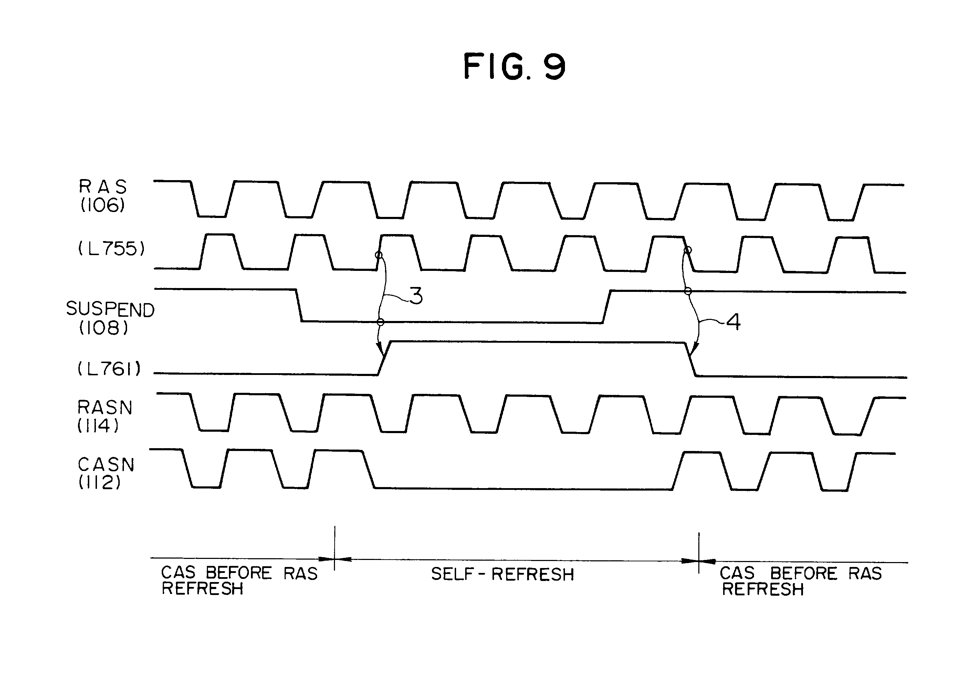

In the next place, with reference to FIG 9, there are described hereinafter a process of switching from the CAS before RAS refresh to the data holding by the dynamic RAM and returning the CAS before RAS refresh again, and the self-refresh operation in the data holding by the dynamic RAM.

There will be described a switching operation indicated by an arrow 3 with reference to FIGs. 8 and 9.

The refresh switching circuit is constituted of such a circuit already described with reference to the circuit diagram shown in FIG. 8 from which the gates 714 and 717 are omitted.

In the switching for the self-refresh, when the SUSPEND signal 108 becomes the "L" level, the output signal on the output signal line 2761 from the gate 707 becomes "H" level at the rising of the output signal on the output signal line L755 from the gate 704 appearing thereafter so as to satisfy the logical condition of the composite gate G718 and, on the other hand, to permit the CASN signal 114 to become the "L" level.

The self-refresh is started in this situation, and the dynamic RAM is refreshed each time the RASN signal 112 is inputted, keeping the CASN signal 114 at the "L" level.

In the self-refresh mode, when there is no input of the RAS signal 106, namely, when both the CPU 101 and the system logic 110 are inactive, a clock signal is fed from the external terminal (EXT) into an input terminal of the gate G701. Accordingly, it becomes possible to hold data in the dynamic RAM array 115 with a remarkably lower consumed electric power, provided that the clock input has a cycle time within the allowable range of data holding times in the dynamic RAM array 115.

In the next place, there will be described a switching operation indicated by an arrow 4 with reference to FIGs. 8 and 9.

The SUSPEND signal 108 firstly becomes the "H" level, the output signal on the output signal line L761 of the gate G707 becomes the "L" level at the falling of the output signal on the output signal line L755 of the gate G704 appearing thereafter, and hence the CASN signal 114 becomes the "H" level.

Hereby, the self-refresh is completed and the operation returns to the CAS-before-RAS refresh.

By the above described switching circuit, the switch between the CAS-before-RAS refresh and the self refresh is easily achieved, and further the data holding (suspension) by the dynamic RAM can be carried out with a lower consumed electric power.

It is herein noted that the RESET signal 116 becomes the "L" level in a certain time during the system power supply being on to initialize the electronic circuits such as the flip-flops.

### Industrial Utility

As clarified from the above arrangement of the present invention, in a personal computer incorporating a dynamic RAM according to the present invention a consumed current through the personal computer is greatly reduced and data holding by the dynamic RAM with a lower consumed current is ensured.

Additionally, addition of such a dynamic RAM refresh circuit to prior art personal computers ensures compatibility with those prior art computers in view of both hardware and software.

## Claims

1. A microprocessor system including a central processor (101), system logic (110) (110) and a dynamic RAM, said dynamic RAM including a dynamic RAM array (115) and characterised by a refresh switching circuit (111) responsive to control signals (RAS, CAS, HOLDA, REFRESHN) from the system logic (110) indicative of the need to perform a RAS-only refresh of the dynamic RAM array (115) to generate refresh signals (RASN, CASN) causing the dynamic RAM array (115) to perform a CAS-before-RAS refresh cycle.

2. A microprocessor according to claim 1 characterised in that said refresh switching circuit (111) includes means for performing a switching operation between said CAS-before-RAS refresh and self-refresh, thereby providing a data holding by said dynamic RAM array (115) with a lower consumed electric power.

3. A microprocessor system according to claim 1 characterised by an external terminal (EXT) for inputting thereto a clock signal having a periodic time within the allowable range of data holding time in said dynamic RAM array (115), thereby enabling said refresh switching circuit (111) to continuously perform the self-refresh operation even when both said central processor (101) and said system logic (110) are stopped during the self-refresh operation.

## Patentansprüche

1. Mikroprozessorsystem mit einem Zentralprozessor (101), einer Systemlogik (110) und einem dynamischen RAM, wobei der dynamische RAM ein Feld (115) dynamischer RAM's aufweist,
**gekennzeichnet durch** einen Auffrischschalterkreis (111), der auf Steuersignale (RAS, CAS, HOLDA, REFRESHN) von der Systemlogik (110) antwortet, die die Notwendigkeit der Durchführung nur einer RAS-Auffrischung des Feldes (115) dynamischer RAM's anzeigen, um Auffrischsignale (RASN, CASN) zu erzeugen, wodurch bewirkt wird, daß das Feld (115) dynamischer RAM's einen CAS-vor-RAS Auffrischzyklus durchführt.

2. Mikroprozessor nach Anspruch 1, dadurch gekennzeichnet, daß der Auffrischschalterkreis (111) Mittel zum Durchführen einer Schaltoperation zwischen der CAS-vor-RAS Auffrischung und einer Selbstauffrischung aufweist, wobei ein Halten von Daten durch das Feld (115) dynamischer RAM's mit einem niedrigeren elektrischen Leistungsverbrauch vorgesehen wird.

3. Mikroprozessor nach Anspruch 1, gekennzeichnet durch einen externen Anschluß (EXT) zum Eingeben eines Taktsignals, das eine Periodenzeit in dem zulässigen Bereich der Datenhaltezeit in dem Feld (115) dynamischer RAM's aufweist, wobei der Auffrischschalterkreis (111) kontinuierlich die Selbstauffrischoperation durchführen kann, selbst wenn sowohl der Zentralprozessor (101) als auch die Systemlogik (110) während der Selbstauffrischoperation gestoppt werden.

## Revendications

1. Système de microprocesseur incluant un processeur central (101), une logique système (110) et une RAM dynamique, ladite RAM dynamique incluant un réseau de RAM dynamique (115), caractérisé par un circuit de commutation de rafraîchissement (111) sensible à des signaux de commande (RAS, CAS, HOLDA, REFRESHN) provenant de la logique système (110) indicatifs de la nécessité de réaliser un rafraîchissement à RAS seulement du réseau de RAM dynamique (115) afin de générer des signaux de rafraîchissement (RASN, CASN) forçant le réseau de RAM dynamique (115) à réaliser un cycle de rafraîchissement à CAS avant RAS.

2. Microprocesseur selon la revendication 1, caractérisé en ce que ledit circuit de commutation de rafraîchissement (111) inclut un moyen pour réaliser une opération de commutation entre ledit rafraîchissement à CAS avant RAS et un auto-rafraîchissement pour ainsi assurer un blocage des données au moyen dudit réseau de RAM dynamique (115) moyennant une énergie électrique consommée plus faible.

3. Système de microprocesseur selon la revendication 1, caractérisé par une borne externe (EXT) pour entrer dessus un signal d'horloge présentant un temps périodique dans la plage autorisée du temps de blocage des données dans ledit réseau de RAM dynamique (115) pour ainsi permettre audit circuit de commutation de rafraîchissement (111) de réaliser en continu l'opération d'auto-rafraîchissement même lorsqu'à la fois ledit processeur central (101) et ladite logique système (110) sont arrêtés pendant l'opération d'auto-rafraîchissement.
